# FASCICULE DE BREVET EUROPEEN

(11) **EP 0 317 862 B1**
(45) Date de publication et mention de la délivrance du brevet: **31.03.1993**
(21) Numéro de dépôt: 88118948.4
(22) Date de dépôt: 14.11.1988
(51) Int. Cl.: H03G 3/34

(54) **Dispositif d'amélioration du confort d'écoute par suppression des phénomènes transitoires dans une chaîne de réception d'un équipement FM/PM à bande étroite, notamment en radiotéléphonie**
Vorrichtung zur Verbesserung des Hörkomforts durch Unterdrückung der Einschwingvorgänge in einer Empfangskette einer FM/PM-Schmalbandeinrichtung, insbesondere für Funkfernsprechen
Device for enhancing hearing comfort by suppressing the transient phenomena in a reception chain of a narrow band FM/PM equipment, particularly in radiotelephony

(30) Priorité: 19.11.1987 FR 8716010
(43) Date de publication de la demande: 31.05.1989
(73) Titulaire: ALCATEL RADIOTELEPHONE, 75008 Paris (FR)
(72) Inventeur: Genty, Gérard, F-78780 Maurecourt (FR); Varin, Joel, F-95520 Osny (FR); Belicaud, Michel, F-95130 Franconville (FR)
(74) Mandataire: Weinmiller, Jürgen

(56) Documents cités:
- WO-A-87/06072
- DE-A- 2 364 249
- US-A- 3 678 416
- US-A- 4 143 333
- US-A- 4 327 446
- GRUNDIG - TECHNISCHE INFORMATIONEN, vol. 27, no. 4/5, 1980, pages 259-271, Furth, DE; R. ROTH: "Der Verkehrsfunk-Coder VC 6"
- PATENT ABSTRACTS OF JAPAN, vol. 7, no. 119 (E-177), 24 mars 1983, page 131 E 177 & JP-A-58 39 126
- PATENT ABSTRACTS OF JAPAN, vol. 10, no. 150, (E-408), 31 mai 1986, page 109 E 408 & JP-A-61 10 327
- PATENT ABSTRACTS OF JAPAN, vol. 8, no. 84 (E-239), 18 avril 1984, page 148 E 239 & JP-A-59 5752
- ELECTRONIC ENGINEERING, vol. 51, no. 629, octobre 1979, pages 97-108, Londres, GB; R. BINNION: "Design and applications of lumped constant delay lines"

## Description

L'invention concerne un dispositif d'amélioration du confort d'écoute par suppression des phénomènes transitoires dans une chaîne de réception d'un équipement FM/PM (modulation de fréquence/modulation de phase) à bande étroite, notamment en radiotéléphonie.

L'utilisation de la modulation FM/PM dans les équipements de radiotéléphonie entraîne l'apparition d'un certain nombre de défauts dûs aux évanouissements lents ou rapides de la porteuse, particulièrement génants sur le plan acoustique.

Si l'on observe le signal de sortie d'une chaîne de réception FM/PM recevant une porteuse non modulée à l'entrée antenne, on constate l'existence d'impulsions qui proviennent de la combinaison vectorielle du bruit et du signal utile.

Ces phénomènes apparaissent d'autant plus que le rapport signal à bruit est faible et ils induisent des parasites ("click" ou phénomènes transitoires) très désagréables dans l'écouteur ; leur apparition est aléatoire. On peut d'ailleurs les caractériser par un certain nombre de paramètres :
- Distribution statistique de leur amplitude ;
- Distribution statistique de leur durée ;
- Fréquence d'apparition ; Ces statistiques dépendent notamment des données suivantes :
- Largeur du filtre à quartz de la chaîne de réception ;
- Rapport signal à bruit à l'entrée du discriminateur de ladite chaîne ;
De plus lorsqu'une chaîne de réception est utilisée dans un mobile en mouvement, il apparait un phénomène, lié à l'existence de multitrajets, qui peut être interprêté en terme de "Fading ou d'évanouissement périodique. On montre que la distribution de l'amplitude du signal reçu est régie par une loi de Rayleigh. A chaque "trou de fading" dont la fréquence de récurrence est proportionnelle à la vitesse du véhicule, on aura l'apparition de "clicks" dus à la rotation rapide du vecteur résultant bruit signal et/ou à la diminution importante du rapport signal à bruit, ainsi qu'une remontée du niveau de bruit désagréables pour l'utilisation sur le plan acoustique.

Pour corriger ces défauts, il est connu d'utiliser un système antiparasite basé sur le principe de l'adjonction d'une deuxième tête HF (hautes fréquences) réception dans le matériel afin de détecter le plus tôt possible les parasites et de les bloquer avant leur passage dans le filtre à quartz.

Un tel système présente le désavantage de devoir utiliser une deuxième tête HF et d'effectuer le blocage en HF (Problème de volume et de coût).

De plus la sensibilité des systèmes de détection de l'art connu ne permet pas la prise en compte systématique des "clicks", en particulier ceux de faible amplitude.

Un article de l'art connu paru dans "Grundig - technische informationen" (volume 27, numéros 4/5, 1980, pages 259-271, figures 6 et 7) décrit un dispositif d'élimination de parasites dans un autoradio, dans lequel les impulsions de 30 µs à 50 µs sont éliminées dans un commutateur commandé par un monostable ; ce commutateur étant connecté à un filtre passe-bas. Dans ce dispositif la valeur de tension du signal au début de cette élimination est maintenue, grâce à un condensateur, pendant toute la durée de cette élimination.

Un brevet américain, US-A- 4143333, décrit un appareil pour éliminer des parasites qui comprend un circuit "buffer" d'entrée, un circuit de détection d'impulsions et un circuit de commande de l'élimination, un circuit de retard permettant de retarder suffisamment une impulsion pour pouvoir l'éliminer, et un circuit d'élimination des parasites détectés.

Un autre brevet américain, US-A- 4327446, décrit un circuit éliminateur de bruit qui s'aligne sur le niveau moyen du bruit ; ce circuit comprenant des moyens de détection du bruit, des moyens de génération d'impulsions d'élimination, comportant des moyens d'amplification du bruit et des moyens de commutation de seuils, et des moyens de commutation couplés aux précédents moyens.

L'invention a pour objet une chaîne de réception ayant des performances optimisées telles qu'elle puisse s'intégrer dans des matériels radiotéléphoniques à bande étroite où l'espacement intercanal est de 12,5 à 30KHz et telles qu'elle apporte à l'utilisateur un très bon confort d'écoute, notamment pour une application au téléphone de voiture.

L'invention propose à cet effet un dispositif d'amélioration du confort d'écoute dans une chaîne de réception d'un équipement FM/PM à bande étroite, notamment en radiotéléphonie, ladite chaîne comprenant :
- une tête HF située en sortie d'antenne.;
- au moins un mélangeur recevant un signal oscillateur ;
- un circuit limiteur-amplificateur ;
- un discriminateur ;
- un circuit d'amplication BF (basses fréquences);
- et ledit dispositif comprenant des premiers moyens de détection et d'élimination de phénomènes transitoires, situés en sortie du discriminateur ;
   caractérisé en ce que ces premiers moyens de détection et d'élimination de phénomènes transitoires comprennent :
- d'une part de premiers circuits connectés en série entre l'entrée et la sortie desdits premiers moyens, à savoir :
   . un filtre passe-bas disposé en entrée qui permet la réjection des fréquences indésirables;
   . une ligne à retard dont le temps de propagation de groupe dans la bande de fréquence 300-3000 Hz est constant et d'une valeur d'environ 150 µs;
   . un commutateur analogique ;
   . une mémoire ;
   . un circuit amplificateur;
- d'autre part de seconds circuits connectés en série entre la sortie du filtre passe-bas et une seconde entrée du commutateur analogique, à savoir ;
   . un circuit de détection de transitoires ;
   . un redresseur double alternance ;
   . une logique de commande du commutateur permettant de générer une fenêtre d'une largeur d'environ 500 µs dans laquelle la ligne à retard permet de centrer le parasite.

L'invention permet, avantageusement, de réaliser une détection rapide et à grande dynamique des parasites ; La probabilité de détection et donc d'élimination des parasites est supérieure à 95 % quelle que soit leur amplitude au-dessus du niveau du signal utile.

Les premiers moyens de détection et d'élimination de phénomènes transitoires comportent donc des moyens pour remplacer lesdits phénomène transitoires par une tension dont la valeur instantanée est celle du signal BF avant détection de ces phénomènes transitoires.

L'invention permet donc de remplacer des parasites par des "blancs" quasi inaudibles.

Avantageusement les moyens de détection et d'élimination de phénomènes transitoires comprennent :
. un filtre passe-bas disposé en entrée qui permet la réjection des fréquences indésirables ;
. un circuit amplificateur ;
La logique de commande du commutateur comportant :
- un comparateur à seuil ;
- un monostable redéclenchable d'une durée d'environ 500 µs.

Avantageusement l'invention comporte, en outre, de seconds moyens de régulation de niveau BF reçu situés dans la chaîne après les premiers moyens et avant le circuit d'amplification BF. Ces seconds moyens comprennent :
- entre son entrée et sa sortie un circuit de régulation de niveau et de filtrage à bande passante adaptative ;
- entre une entrée tension de commande et une seconde entrée du circuit de régulation de niveau, un circuit de traitement du signal de commande ;
- un circuit séparateur disposé en entrée ;
- un circuit amplificateur disposé en sortie.

De tels seconds moyens permettent d'obtenir différents avantages, en effet :
- Les conséquences audio fréquences du fading, dans le cas d'un mobile qui se déplace, sont considérablement atténuées ;
- La remontée statistiquement périodique du bruit (dépendante de la vitesse du mobile), traduisant une dégradation de la qualité de la liaison, est réduite et donne à l'utilisateur un confort d'écoute accru.

De plus les différents circuits utilisés, selon l'invention, présentent de nombreux avantages, et notamment :
- Leur simplicité ;
- Leur facilité d'utilisation dans les systèmes radiotéléphones fixes ou mobiles grâce à des solutions aisément intégrables sous la forme d'un circuit intégré de faible taille.

Les caractéristiques et avantages de l'invention ressortiront d'ailleurs de la description qui va suivre, à titre d'exemple non limitatif, en référence aux figures annexées sur lesquelles :
- La figure 1 représente une chaîne de réception FM/PM ;
- La figure 2 représente un dispositif de détection et d'élimination de phénomènes transitoires selon l'invention ;
- La figure 3 représente un dispositif de régulation du niveau BF selon l'invention.

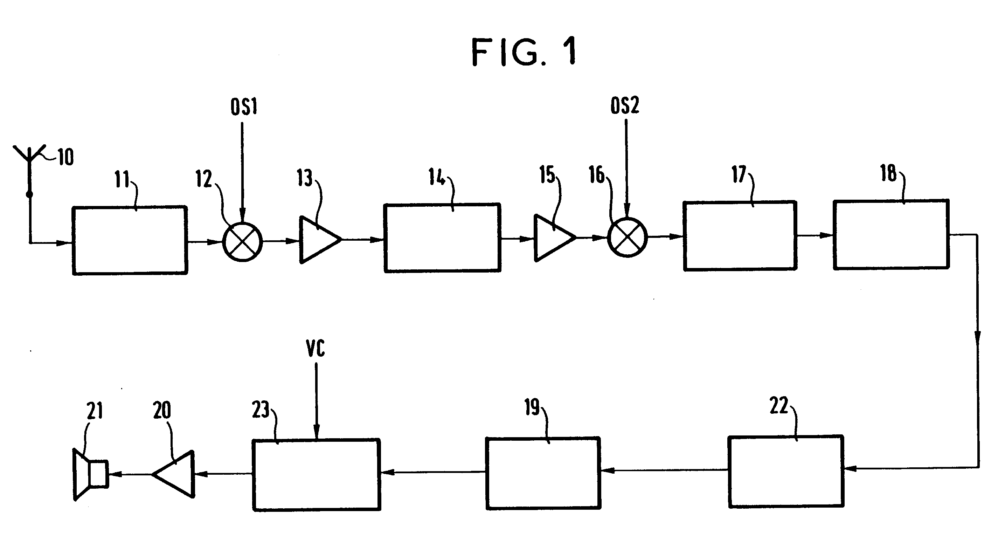

La figure 1 représente une chaîne de réception FM/PM classique (modulation de fréquence/modulation de phase) à double changement de fréquence de démodulation par discrimination de fréquence dans laquelle ont été implantés deux dispositifs selon l'invention.

Une telle chaîne réception de l'art connu comporte :
- Une tête HF (hautes fréquences) 11 située en sortie d'antenne 10;
- Un premier mélangeur 12 à une première fréquence intermédiaire recevant un signal oscillateur OS1 ;
- Un amplificateur 13 optionnel ;
- Un filtre à quartz 14 ;
- Un amplicateur 15 optionnel ;
- un second mélangeur 16 à une seconde fréquence intermédiaire recevant un signal oscillateur OS2;
- un circuit limiteur-amplificateur 17 ;
- un discriminateur 18 ;
- un éventuel circuit de désaccentuation et de filtrage BF 19 ;
- un circuit d'amplification BF (basses fréquences) 20 ;
- un haut-parleur 21.

Dans cette chaîne ont été implantés, selon l'invention, deux dispositifs permettant d'améliorer le confort d'écoute pour l'utilisateur, à savoir :
- un dispositif 22 d'élimination de phénomène transitoires ou "clicks" ;
- un dispositif 23 de régulation du niveau BF recevant un signal de commande Vc qui dépend du niveau de champ reçu.

Le dispositif 22 d'élimination de phénomènes transitoires permet de réaliser le remplacement des parasites, apparaissant dans la chaîne réception d'un équipement, par une tension (bloqueur d'ordre 0) dont la valeur instantanée est celle du signal BF avant détection du parasite. Ca dispositif 22 est juste après le discriminateur 18 pour réagir le plus tôt possible à l'apparition des parasites.

Le dispositif 23 de régulation de niveau BF permet, quant à lui, la régulation du niveau BF et l'adaptation du filtrage BF en présence de fading. Cette opération est possible en utilisant l'image du bruit hors bande du discriminateur 18 ou une information de champ reçu comme tension d'asservissement. Ce dispositif 23 de régulation est situé après le dispositif 22 d'élimination de phénomènes transitoires, les deux dispositifs étant des circuits à bas niveau donc toujours situés avant l'amplificateur BF 20.

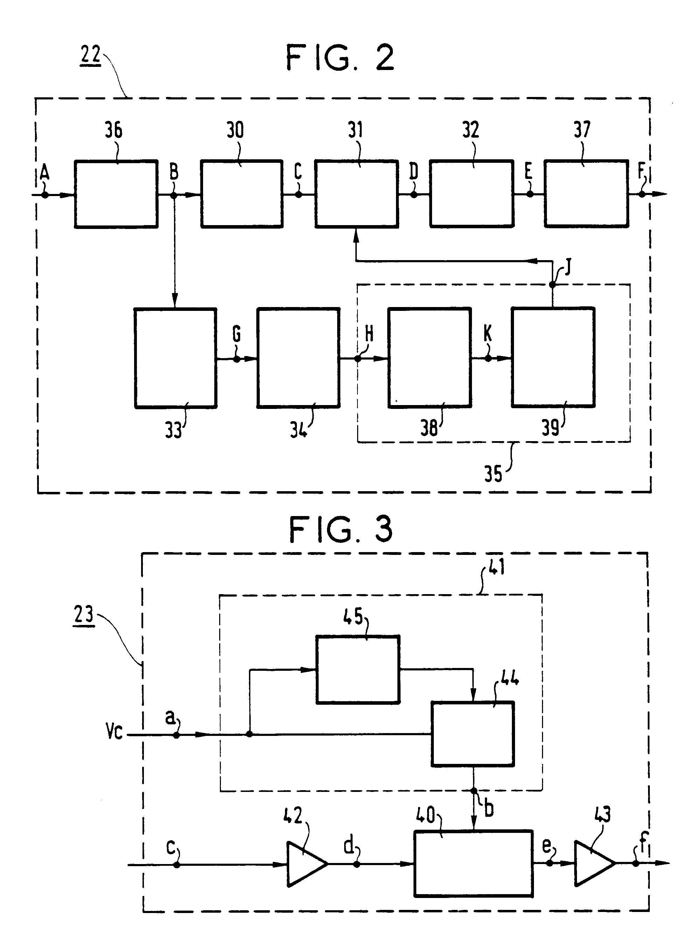

Le dispositif 22 éliminateur de transitoires, qui reçoit le signal issu du discriminateur de fréquence du récepteur, comprend comme représenté à la figure 2 :
- d'une part de premiers circuits connectés en série entre l'entrée (A) et la sortie (F) dudit dispositif, à savoir :
   . une ligne à retard 30 dont le temps de propagation de groupe dans la bande de fréquence 300-3000 Hz est constant et d'une valeur d'environ 150 µs, ce qui permet notamment de compenser le temps de traitement ;
   . un commutateur analogique 31 ;
   . une mémoire 32 ;
- d'autre part de seconds circuits connectés en série entre la sortie (B) du filtre passe-bas et une seconde entrée du commutateur analogique 31, à savoir :
   . un circuit de détection de transitoires 33 ;
   . un redresseur double alternance 34 ;
   . une logique de commande 35 du commutateur 31 permettant de générer une fenêtre d'une largeur d'environ 500 µs dans laquelle la ligne à retard à pour rôle de centrer le parasite.

Avantageusement ce dispositif 22, représenté en figure 2, comprend en outre :
- un filtre passe-bas 36 disposé en entrée qui permet la réjection des fréquences indésirables (Produits de mélange du récepteur par exemple) ;
- un circuit amplificateur 37 qui permet une correction de gain telle qu'en régime sinusoïdal établi une fonction de transfert de gain unité existe entre l'entrée (point A) et la sortie (point F) dans la gamme de fréquences 300-3000 Hz.

La logique 35 de commande du commutateur 31 peut comporter :
- un comparateur à seuil 38 ;
- un monostable redéclenchable 39 d'une durée d'environ 500 µs.

Dans un exemple de réalisation, le signal issu du discriminateur 18 de fréquence de la chaîne (Point A) est d'abord appliqué au filtre actif passe bas 36, à 4 pôles, de fréquence de coupure 50 KHZ. Ce filtre passe bas est composé par exemple de deux amplificateurs opérationnels (montage en source contrôlée) connectés en cascade, chaque cellule étant d'ordre 2.

Le signal (Point B) est alors appliqué à une fonction retard 30 dont le temps de propagation de groupe dans la bande de fréquence 300-3000 HZ est constant et d'une valeur d'environ 150 µs. Ce retard permet, d'une part, de compenser le temps nécessaire à la détection du parasite et, d'autre part, de centrer ce parasite dans une fenêtre d'une largeur d'environ 500 µs. Cette ligne à retard 30 se présente sous forme d'un filtre actif passe bas 12 pôles de fréquence de coupure 5 KHZ par exemple. Ce filtre passe bas est composé par exemple de six amplificateurs opérationnels (Montage en Source Contrôlée) connectés en cascade, chaque cellule étant d'ordre 2. Le signal retardé est ensuite appliqué au commutateur analogique 31 (Point C).

En absence de "clicks" le signal est transmis au Point D.

En présence de "clicks", le commutateur 31 est ouvert sous la dépendance de la commande 35 (Point J). Dans ce cas, la valeur instantanée du signal BF précédant l'ouverture de l'interrupteur est mise en mémoire 32 et transmise pendant l'ouverture du commutateur analogique (≃500 µs).

Le parasite a donc été remplacé par un "blanc", ce qui améliore considérablement le confort d'écoute : En effet un blanc d'environ 500 µs n'entraîne aucune gêne à l'écoute.

La mémoire 32 est réalisée par exemple par un condensateur dont la décharge est minimisée par la mise en interface d'un étage à haute impédance d'entrée.

Le signal issu de la fonction mémoire (Point E) est appliqué à un circuit amplificateur 37 : La correction de gain permet d'obtenir entre les Points A et F, en régime sinusoïdal établi, une fonction de transfert de gain unité dans la gamme de fréquence 300-3000 HZ (bané de BF).

Au point B est connecté le système de détection. Celui-ci est organisé autour d'un circuit 33 à commande automatique de gain. Les constantes de temps de la boucle d'asservissement de ce circuit sont optimisées pour réguler le signal utile BF et présenter un gain maximal aux parasites se trouvant à l'entrée du circuit : Ceux-ci sont fortement amplifiés dans les limites de la dynamique du circuit. Leur niveaux respectifs devenant très supérieurs à celui du signal utile, il devient plus facile de les discriminer.

Afin de traiter tous les parasites quelle que soit leur polarité, le circuit détecteur 33 est suivi d'une fonction redresseur double alternance 34. Ce redresseur double alternance 34 est organisé autour d'un amplicateur opérationnel comprenant par exemple deux diodes dans la voie de contre réaction.

Le signal (utile + parasite) est ensuite appliqué au dispositif à seuil 38 comparant le niveau du signal incident à un seuil fixe ; Chaque fois qu'un parasite est détecté, la sortie du comparateur (Point K) change d'état et commande la mise en service du circuit monostable (39) qui élabore la commande logique (Point J) du commutateur analogique 31. Ce circuit monostable 39 est redéclenchable et réagit à l'apparition de chaque phénomène parasite. La durée de l'ouverture du commutateur 31 est voisine de 500 µs.

Le dispositif 23 de régulation de niveau BF, comme représenté à la figure 3, se compose de deux circuits essentiels :
- un circuit 41 de traitement du signal de commande ;
- un circuit 40 de régulation de niveau et de filtrage à bande passante adaptative.

En effet, l'amplitude du signal (utile + bruit) n'est pas constante. Elle varie en fonction du rapport signal à bruit, qui se dégrade en présence de Fading. La remontée du niveau de bruit, lors des trous de fading gêne considérablement l'écoute.

En fonction des variations de la tension représentative du champ reçu, le gain de la chaîne audiofréquence est modifié de telle sorte que le niveau moyen reste constant.

D'autre part, et simultanément, la bande passant audiofréquence est aussi asservie à l'information de champ reçu. Lorsque le champ reçu est faible ce qui correspond à un rapport signal à bruit dégradé, la bande passant BF est alors réduite, ce qui permet l'amélioration de la qualité de la phonie. Au contraire, lorsque le rapport signal à bruit est suffisant pour assurer une bonne qualité de la phonie, le gabarit de filtrage est élargi et n'influe pas sur le filtrage originel de l'équipement.

Dans ce dispositif 23 de régulation de niveau BF l'information du niveau de champ reçu est utilisée pour effectuer la régulation du niveau et l'adaptation du gabarit de filtrage.

La valeur absolue de la mesure du champ reçu n'est pas le paramètre intéressant puisque le fading peut exister quel que soit le champ disponible à l'entrée du récepteur ; il est donc préférable d'effectuer un traitement permettant l'extraction et l'utilisation des variations relatives de la mesure de champ reçu.

Ce dispositif de régulation du niveau BF, comme représenté en figure 3, comprend :
- d'une part, entre son entrée (c) et sa sortie (f), un circuit 40 de régulation de niveau et de filtrage à bande passante adaptative
- et d'autre part, entre une entrée (a) tension de commande et une seconde entrée du circuit de régulation de niveau (40), un circuit (41) de traitement du signal de commande.

Avantageusement ce dispositif, représenté en figure 3, comprend en outre :
- un circuit séparateur 42 disposé en entrée ;
- un circuit amplificateur 43 disposé en sortie.

Dans un exemple de réalisation, au point a est appliquée la tension Vc, image du champ reçu. Cette tension est aiguillée sur deux voies. L'une est appliquée directement à un soustracteur 44, l'autre est d'abord intégrée (45) avant d'être appliquée au soustracteur 44 précédemment cité. Cette opération réalise l'élimination de la valeur moyenne absolue du champ reçu et extrait les variations relatives de la tension image du champ reçu. Ce signal est disponible au point b.

Au point C est appliqué le signal audiofréquence. Après avoir traversé l'étage séparateur 42, le signal est appliqué à la fonction de régulation et de filtrage 40. La commande continue image du niveau de champ reçu décrite précédemment est appliquée à la fonction au point b.

Pour des variations de champ reçu de 10 décibels environ, le niveau du signal (utile + bruit) en sortie de la fonction est maintenu constant grâce au contrôle automatique de gain.

Simultanément en fonction d'un critère de qualité de la réception déterminé par la tension d'asservissement au point b, la bande passante basse fréquence peut être réduite afin d'améliorer le rapport signal à bruit tout en conservant une intelligibilité acceptable de la communication. L'adaptation de la bande passante n'est active que dans le cas où le rapport signal à bruit est faible. Ceci correspond à une remontée important du bruit ce qui entraîne une sensation d'écoute difficile et désagréable.

Le signal de sortie (Point e) est ensuite appliqué à une fonction amplificatrice 43 qui permet l'ajustement du gain.

Dans les conditions normales de fonctionnement, c'est à dire au point neutre de la commande automatique de gain et pour un gabarit de filtrage adaptatif inactif vis à vis du filtrage normal du récepteur, le gain est unité entre les points c et f.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi la chaîne de réception de l'art connu, dans laquelle ont été implantés les circuits de mise en oeuvre de l'invention, a été prise uniquement à titre d'exemple.

## Revendications

1. Dispositif d'amélioration du confort d'écoute dans une chaîne de réception d'un équipement FM/PM à bande étroite, notamment en radiotéléphonie ; ladite chaîne comprenant :
- une tête HF (11) située en sortie d'antenne (10) ;
- au moins un mélangeur (12, 16) recevant un signal oscillateur (OS1, OS2) ;
- un circuit limiteur-amplificateur (17) ;
- un discriminateur (18) ;
- un circuit d'amplification BF (20) ;
- et ledit dispositif comprenant des premiers moyens (22) de détection et d'élimination de phénomènes transitoires, situés en sortie du discriminateur (18),
caractérisé en ce que ces premiers moyens de détection et d'élimination de phénomènes transitoires comprennent :
- d'une part de premiers circuits connectés en série entre l'entrée (A) et la sortie (F) desdits premiers moyens à savoir :
. un filtre passe-bas (36) disposé en entrée qui permet la réjection des fréquences indésirables ;
. une ligne à retard (30) dont le temps de propagation de groupe dans la bande de fréquence 300-3000 Hz est constant et d'une valeur d'environ 150 µs ;
. un commutateur analogique (31) ;
. une mémoire (32) ;
. un circuit amplificateur (37) ;
- d'autre part de seconds circuits connectés en série entre la sortie (B) du filtre passe-bas et l'entrée de commande du commutateur analogique, à savoir ;
. un circuit de détection de transitoires (33) ;
. un redresseur double alternance (34) ;
. une logique de commande (35) du commutateur comportant un comparateur à seuil (38) et un monostable redéclenchable (35) d'une durée d'environ 500 µs, permettant de générer une fenêtre d'une largeur d'environ 500 µs dans laquelle la ligne à retard permet de centrer le parasite.

2. Dispositif selon la revendication 1, caractérisé en ce que la ligne à retard (30) comprend un filtre actif 12 pôles formé de six amplificateurs opérationnels connectés en cascade.

3. Dispositif selon la revendication 1, caractérisé en ce que la mémoire (32) comprend un condensateur dont la décharge est minimisée par la mise en interface d'un étage à haute impédance d'entrée.

4. Dispositif selon la revendication 1, caractérisé en ce que le filtre passe bas (36) est un filtre actif 4 pôles, de fréquence de coupure 50 kHz, composé de deux amplificateurs opérationnels connectés en cascade.

5. Dispositif selon l'une quelconque des revendications précédentes, caractérisé en ce qu'il comprend de seconds moyens (23) de régulation du niveau BF du signal reçu situés dans la chaîne après les premiers moyens et avant le circuit d'amplification BF (20).

6. Dispositif selon la revendication 5, caractérisé en ce que les seconds moyens de régulation du niveau BF comprennent :
- d'une part, entre son entrée (c) et sa sortie (f), un circuit (40) de régulation de niveau et de filtrage à bande passante adaptative ;
- et d'autre part, entre une entrée (a) tension de commande et une seconde entrée (b) du circuit de régulation de niveau (40), un circuit (41) de traitement du signal de commande.

7. Dispositif selon la revendication 6, caractérisé en ce que le dispositif de régulation de niveau BF comprend en outre :
- un circuit séparateur (42) disposé en entrée ;
- un circuit amplificateur (43) disposé en sortie.

8. Dispositif selon la revendication 6, caractérisé en ce que le circuit de traitement (41) du signal de commande comprend un soustracteur (44), le signal de commande étant directement appliqué à l'une des entrées de ce soustracteur (44), et étant appliqué, après passage dans un intégrateur (45) à une seconde entrée dudit soustracteur (44).

## Claims

1. Device for enhancing hearing comfort in a reception chain of a narrow band FM/PM equipment, particularly in radiotelephony, said chain comprising:
- an HE tuner head (11) connected to the output of an antenna (10);
- at least one mixer (12, 16) receiving a signal from an oscillator;
- a limiter-amplifier circuit (17);
- a discriminator (18);
- an AF amplifier circuit (20);
- and said device comprising means (22) for detecting and eliminating first transient phenomena connected to the output of the discriminator (18);
characterised in that said transient phenomena detector and eliminator first means comprise:
- firstly, first circuits connected in series between the input (A) and the output (F) of said first means, namely:
. a low-pass filter (36) at the input for rejecting unwanted frequencies;
. a delay line (30) whose group delay time in the 300 - 3 000 Hz frequency band is constant at approximately 150 µs;
. an analogue switch (31);
. a memory (32);
. an amplifier circuit (37);
- secondly, second circuits connected in series between the output (B) of the low-pass filter and a second input of the analogue switch (31), namely:
. a transient detector circuit (33);
. a full-wave rectifier (34);
. control logic (35) for the switch comprising a threshold comparator (38) and a retriggerable monostable (35) with a period of approximately 500 µs for generating a window approximately 500 µs wide in which the delay line enables the interference to be centred.

2. Device according to claim 1 characterised in that the delay line (30) comprises a 12-pole active filter in the form of six operational amplifiers connected in cascade.

3. Device according to claim 1 characterised in that the memory (32) comprises a capacitor discharging of which is minimised by the use of a high input impedance interface stage.

4. Device according to claim 1 characterised in that the low-pass filter (36) is a four-pole active filter with a cut-off frequency of 50 kHz comprising two operational amplifiers connected in cascade.

5. Device according to any one of the preceding claims characterised in that it comprises second means (23) for regulating the AF level of the receive signal disposed after the first means and before the AF amplifier circuit (20).

6. Device according to claim 5 characterised in that the AF level regulator second means comprise:
- firstly, between its input (c) and its output (f), an adaptive bandwidth filter and regulator circuit (40); and
- secondly, between a control voltage input (a) and a second input (b) of the level regulator circuit (40), a control signal processor circuit (41).

7. Device according to claim 6 characterised in that the AF level regulator device further comprises:
- a splitter circuit (42) at the input;
- an amplifier circuit (43) at the output.

8. Device according to claim 6 characterised in that the control signal processor circuit (41) comprises a subtractor (44), the control signal being applied directly to one input of said subtractor (44) and being applied via an integrator (45) to a second input of said subtractor (44).

## Patentansprüche

1. Einrichtung zur Verbesserung des Hörkomforts bei einer schmalbandigen Empfangskette eines FM/PM-Gerätes, insbesondere für den Funksprechverkehr, wobei die Kette aufweist:
- einen HF-Kopf (11) am Ausgang der Antenne (10);
- mindestens einen Mischer (12, 16), der ein Oszillatorsignal (OS1, OS2) empfängt;
- eine Begrenzer-Verstärkerschaltung (17);
- einen Diskriminator (18);
- eine NF-Verstärkerschaltung (20);
- und wobei die Einrichtung am Ausgang des Diskriminators (18) erste Mittel (22) zum Erfassen und Ausscheiden von Übergangsphänomenen aufweist;
dadurch gekennzeichnet, daß diese ersten Mittel zum Erfassen und Ausscheiden der Übergangsphänomene aufweisen:
- einerseits erste Schaltungen, die in Reihe zwischen den Eingang (A) und den Ausgang (F) der ersten Mittel geschaltet sind, nämlich:
. ein Tiefpaßfilter (36) am Eingang, das die Sperrung ungewünschter Frequenzen ermöglicht;
. eine Verzögerungsleitung (30), deren Gruppenlaufzeit im Frequenzband von 300 - 3000 Hz konstant ist und einen Wert von ungefähr 150 µs besitzt;
. einen analogen Schalter (31);
. einen Speicher (32);
. eine Verstärkerschaltung (37);
- andererseits zweite Schaltungen, die in Reihe zwischen den Ausgang (B) des Tiefpaßfilters und den Steuereingang des analogen Schalters geschaltet sind, nämlich
. eine Schaltung zur Erfassung der Übergangsphänomene (33);
. einen Vollweggleichrichter (34);
. eine Steuerlogik (35) für den Schalter, die einen Schwellenkomparator (38) und einen für eine Dauer von 500 µs instabilen monostabilen Kippkreis, der die Erzeugung eines Fensters von ungefähr 500 µs Breite erlaubt, in welchem die Verzögerungsleitung das Zentrieren des Störsignals ermöglicht.

2. Einrichtung nach Anspruch 1, dadurch gekennzeichnet, daß die Verzögerungsleitung (30) ein 12-poliges aktives Filter aufweist, das aus sechs in Kaskade geschalteten Operationsverstärkern aufgebaut ist.

3. Einrichtung nach Anspruch 1, dadurch gekennzeichnet, daß der Speicher (32) einen Kondensator aufweist, dessen Entladung durch die Einfügung einer Stufe mit hoher Eingangsimpedanz minimiert wird.

4. Einrichtung nach Anspruch 1, dadurch gekennzeichnet, daß das Tiefpaßfilter (36) ein 4-poliges aktives Filter mit einer Grenzfrequenz von 50 kHz ist, das aus zwei in Kaskade geschalteten Operationsverstärkern besteht.

5. Einrichtung nach einem beliebigen vorhergehenden Anspruch, dadurch gekennzeichnet, daß sie zweite Mittel (23) zur Regelung des NF-Pegels des empfangenen Signals aufweist, die in der Kette hinter den ersten Mitteln und vor der NF-Verstärkerschaltung (20) angeordnet sind.

6. Einrichtung nach Anspruch 5, dadurch gekennzeichnet, daß die zweiten Mittel zur Regelung des NF-Pegels aufweisen:
- einerseits zwischen ihrem Eingang (c) und ihrem Ausgang (f) eine Schaltung (40) zum Regeln des Pegels und zur Filterung mit anpaßbarem Durchlaßband; und
- andererseits zwischen ihrem Steuerspannungseingang (a) und einem zweiten Eingang (b) der Schaltung eine Steuersignalbearbeitungsschaltung (41).

7. Einrichtung nach Anspruch 6, dadurch gekennzeichnet, daß die Einrichtung zur Regelung des NF-Pegels weiter aufweist
- eine am Eingang angeordnete Trennschaltung (42);
- eine am Ausgang angeordnete Verstärkerschaltung (43);

8. Einrichtung nach Anspruch 6, dadurch gekennzeichnet, daß die Schaltung (41) zur Bearbeitung des Steuersignals ein Subtrahierglied (44) aufweist, wobei das Steuersignal an einen der Eingänge dieses Subtrahiergliedes (44) unmittelbar angelegt wird und an einen zweiten Eingang des Subtrahiergliedes (44) nach Durchlaufen eines Integriergliedes (45) angelegt wird.
